# EUROPEAN PATENT APPLICATION

(11) **EP 1 542 029 A2**
(43) Date of publication of application: **15.06.2005**
(21) Application number: 04029484.5
(22) Date of filing: 13.12.2004
(51) Int. Cl.: G01R 31/28

(54) **Surface mounting electronic module and method of testing the same**

(30) Priority: 12.12.2003 JP 2003415497
(71) Applicant: ALPS ELECTRIC CO., LTD., Tokyo 145-8501 (JP)
(72) Inventor: Yamamoto, Yukimasa Alps Electric Co., Ltd., Tokyo 145-8501 (JP)
(74) Representative: Klunker . Schmitt-Nilson . Hirsch

(57) **Abstract**

The present invention provides a surface mounting electronic module and a method of testing the same capable of simplifying a detection of a positioned state without an electric circuit being broken at the time of electric testing. The surface mounting electronic module of the present invention comprises a square or rectangular insulating substrate 1 having formed with a desired electric circuit; and a plurality of terminal groups 3 and 4. The plurality of terminal groups 3 and 4 have a plurality of external circuits connecting terminal portions 7, three grounding terminal portions 8 connected to a grounding conductor and one non-conductive portion 9. In addition, the three grounding terminal portions 8 are arranged at three point symmetric locations positioned around a center C of the insulating substrate 1 in an equal distance, and the non-conductive portion 9 is arranged at one location. As a result, its structure is simple. The voltage detecting means 15 can suitably determine whether the surface mounting electronic module is positioned in a normal state or in an abnormal state with respect to a guide member 12. Therefore, the electric circuit is not broken when the electric testing is performed.

## Description

### BACKGROUND OF THE INVENTION

### 1. Field of the Invention

The present invention relates to a surface mounting electronic module that is suitable for a short-distance wireless apparatus or semiconductor device and a method of testing the same.

### 2. Description of the Related Art

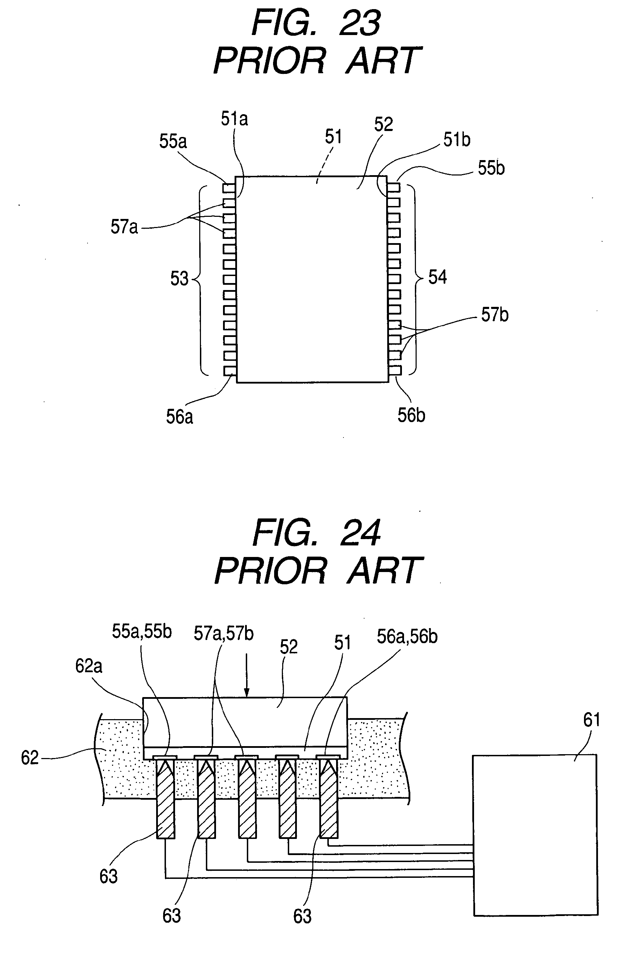

A conventional surface mounting electronic module and a method of testing the same will be described with reference to the accompanying drawings. FIG. 23 is a plan view of a conventional surface mounting electronic module and FIG. 24 is an explanatory view illustrating an outline of a method of testing the conventional surface mounting electronic module.

Next, a structure of the conventional surface mounting electronic module will be described with reference to FIG. 23. An insulating substrate 51 used for a semiconductor device or the like has a rectangular shape, a desired electric circuit (not shown) is formed on one surface of the insulating substrate 51, and the electric circuit is covered with a covering member 52 such as a covering portion or a cover.

In addition, the insulating substrate 51 has a pair of opposing sides 51a and 51b. In the insulating substrate 51, terminal groups 53 and 54 arranged in line along each of the sides 51a and 51b are provided.

The terminal groups 53 and 54 have two power supply voltage terminal portions 55a and 55b arranged on two corner portions of the insulating substrate 51, two grounding voltage terminal portions 56a and 56b arranged on another two corner portions of the insulating substrate 51 and a plurality of external connecting terminal portions 57a and 57b.

In addition, the power supply voltage terminal portions 55a and 55b, the grounding voltage terminal portions 56a and 56b and the external connecting terminal portions 57a and 57b are formed of terminals made of metal plates, and protrude outward from the sides 51a and 51b of the insulating substrate 51 in a state in which they are connected to an electric circuit formed on the insulating substrate 51.

In addition, the conventional surface mounting electronic module having the above-mentioned structure is constituted such that the surface mounting electronic module is mounted on a mother substrate (not shown) of an electronic apparatus or the like, its terminal groups 53 and 54 are soldered on a wiring pattern of the mother substrate and the surface mounting electronic module is surface-mounted on the electronic apparatus (for example, see Japanese Unexamined Patent Application Publication No. 8-186227).

The conventional surface mounting electronic module having the above-mentioned structure is electrically tested prior to shipment. A testing device will be described with reference to FIG. 24. The testing device includes a measuring instrument 61 for measuring an electric value, a guide member 62 having a concave portion 62a for locating the surface mounting electronic module, and a plurality of probes 63 attached to the guide member 62 and connected to the measurement instrument 61.

Next, a test method will be described. First, the surface mounting electronic module is inserted in the concave portion 62a in a state in which the rectangular insulating substrate 51 is guided in the concave portion 62a of the guide member 62.

At this time, the plurality of probes 63 comes into contacts with the power supply voltage terminal portions 55a and 55b, the grounding voltage terminal portions 56a and 56b and the external connecting terminal portions 57a and 57b. At this state, the measurement instrument 61 supplies the terminal groups 53 and 54 with a power supply voltage and a testing signal and thus various electric values are tested.

However, the conventional surface mounting electronic module having the rectangular insulating substrate 51 has two inserting types with regard to the concave portion 62a. According to a first inserting type, the power supply voltage terminal portions 55a and 55b are positioned at a left side of the concave portion 62a and the grounding voltage terminal portions 56a and 56b are positioned at a right left of the concave portion 62a, as shown in FIG. 24.

In addition, according to a second inserting type, the grounding voltage terminal portions 56a and 56b are positioned at a left side of the concave portion 62a and the power supply voltage terminal portions 55a and 55b are positioned at a right side of the concave portion 62a, in FIG. 24.

In addition, assuming that the first inserting type is in a normal state of the surface mounting electronic module, the second inserting type becomes an abnormal state of the surface mounting electronic module. As a result, in a state in which the second inserting type is in the abnormal state, when the various electric tests are performed by the testing device, a desired current can not flow into the power supply voltage terminal portions 55a and 55b, the grounding voltage terminal portions 56a and 56b, and the external connecting terminal portions 57a and 57b, so that the electric circuit is broken.

In addition, the conventional surface mounting electronic module has the terminal groups 53 and 54 arranged along the opposing sides 51a and 51b of the rectangular insulating substrate 51. However, the method of testing the conventional surface mounting electronic module does not have a discriminating means for discriminating the terminal groups 53 and 54. Therefore, in the case in which the surface mounting electronic module is positioned in the abnormal state with respect to the guide member 62, when the various electric tests are performed, the electric circuit is broken.

According to the conventional surface mounting electronic module, there is a problem in that although the surface mounting electronic module has the terminal groups 53 and 54 arranged along the opposing sides 51a and 51b of the rectangular insulating substrate 51, since the method of testing the conventional surface mounting electronic module does not have the discriminating means for discriminating the terminal groups 53 and 54, in the case in which the surface mounting electronic module is positioned in the abnormal state with respect to the guide member 62, when the various electric tests are performed, the electric circuit is broken.

Accordingly, the present invention has been made to solve the above-mentioned problems, and it is an object of the present invention to provide a surface mounting electronic module and a method of testing the same capable of simplifying a detection of a positioned state without an electric circuit being broken at the time of electric testing.

According to a first aspect to solve the above-mentioned problems, the present invention provides a surface mounting electronic module comprising: a square or rectangular insulating substrate on which a desired electric circuit is formed; and a plurality of terminal groups arranged along sides of the insulating substrate at least opposing each other. The plurality of terminal groups has a plurality of external circuits connecting terminal portions, three grounding terminal portions connected to a grounding conductor and one non-conductive portion. In addition, the insulating substrate has first to fourth point symmetric locations positioned around a center of the insulating substrate in an equal distance, the three grounding terminal portions are respectively arranged at the first to third locations and the non-conductive portion is arranged at the fourth location.

Further, according to a second aspect to solve the above-mentioned problems, the external circuit connecting terminal portions and the three grounding terminal portions are formed of lands provided on a bottom surface of the insulating substrate or terminals made of a metal plate mounted on the insulating substrate.

Further, according to a third aspect to solve the above-mentioned problems, the non-conductive portion is not electrically connected to the electric circuit and is formed of the land provided on the bottom surface of the insulating substrate or the terminal made of the metal plate mounted on the insulating substrate.

Further, according to a fourth aspect to solve the above-mentioned problems, the non-conductive portion is formed of an insulating portion which does not have the terminal.

Further, according to a fifth aspect to solve the above-mentioned problems, the three grounding terminal portions and the non-conductive portion are arranged at four corners of the insulating substrate.

Further, according to a sixth aspect to solve the above-mentioned problems, the present invention provides a method of testing a surface mounting electronic module comprising: the surface mounting electronic module according to any one of first to fifth aspects; a guide member for positioning the surface mounting electronic module; first probes connected to the external circuit connecting terminal portions; at least three second probes provided so as to correspond to three of the three grounding terminal portions and the non-conductive portion; and a voltage detecting means arranged between the three second probes, wherein the voltage detecting means determines whether the surface mounting electronic module is positioned in a normal state or in an abnormal state with respect to the guide member.

Further, according to a seventh aspect to solve the above-mentioned problems, one of the three second probes is connected to a power supply, the remaining two second probes are connected to a ground. When the one second probe connected to the power supply comes into contact with the non-conductive portion and the remaining two second probes connected to the ground come into contacts with the two grounding terminal portions, the voltage detecting means detects a power supply voltage and determines that the surface mounting electronic module is positioned in the normal state with respect to the guide member. In addition, when the one second probe connected to the power supply comes into contact with the grounding terminal portion and the remaining two second probes connected to the ground come into contacts with the two grounding terminal portions or one grounding terminal portion and the non-conductive portion, the voltage detecting means detects a voltage of 0V and determines that the surface mounting electronic module is positioned in the abnormal state with respect to the guide member.

Furthermore, according to an eighth aspect to solve the above-mentioned problems, the present invention provides a method of testing a surface mounting electronic module comprising: a surface mounting electronic module according to any one of first to fifth aspects and having a rectangular insulating substrate; a guide member for positioning the surface mounting electronic module; first probes connected to the external circuit connecting terminal portions; at least two second probes provided so as to correspond to one grounding terminal and one non-conductive portion or two grounding terminal portions; and a voltage detecting means arranged between the two second probes. The voltage detecting means determines whether the surface mounting electronic module is positioned in a normal state or in an abnormal state with respect to the guide member.

Further, according to a ninth aspect to solve the above-mentioned problems, one of the two second probes is connected to a power supply and the remaining one second probe is connected to a ground. When the one second probe connected to the power supply comes into contact with the non-conductive portion and the remaining one second probe connected to the ground comes into contacts with the one grounding terminal portion, the voltage detecting means detects a power supply voltage. In addition, when the one second probe connected to the power supply comes into contact with the grounding terminal portion and the remaining one second probe connected to the ground comes into contact with another grounding terminal portion, the voltage detecting means detects a voltage of 0V. When the voltage detected by the voltage detecting means is one of the power supply voltage and the voltage of 0V, the voltage detecting means determines that the surface mounting electronic module is positioned in the normal state with respect to the guide member, and when the voltage detected by the voltage detecting means is the other of the power supply voltage and the voltage of 0V, the voltage detecting means determines that the surface mounting electronic module is positioned in the abnormal state with respect to the guide member.

Further, according to a tenth aspect to solve the above-mentioned problems, after the voltage detecting means determines that the surface mounting electronic module is positioned in the normal state with respect to the guide member, an electric test is performed by the first probe.

Further, according to an eleventh aspect to solve the above-mentioned problems, the method of testing the surface mounting electronic module further comprises a testing device for performing an electric test. The testing device is provided with a display unit for determining the normal state or abnormal state of the surface mounting electronic module by a visual observation.

Further, according to a twelfth aspect to solve the above-mentioned problems, the method of testing the surface mounting electronic module further comprises a testing device for performing an electric test. The testing device is provided with a voice generating unit capable of determining the normal state or abnormal state of the surface mounting electronic module by a voice.

A surface mounting electronic module of the present invention comprises a square or rectangular insulating substrate on which a desired electric circuit is formed; and a plurality of terminal groups arranged along sides of the insulating substrate at least opposing each other. The plurality of terminal groups has a plurality of external circuits connecting terminal portions, three grounding terminal portions connected to a grounding conductor and one non-conductive portion. In addition, the insulating substrate has first to fourth point symmetric locations positioned around a center of the insulating substrate in an equal distance, the three grounding terminal portions are respectively arranged at the first to third locations and the non-conductive portion is arranged at the fourth location.

In this way, since the grounding terminal portions are arranged at the first to third point symmetric locations positioned around a center of the insulating substrate in an equal distance and the non-conductive portion is arranged at the fourth location, its structure is simple. In addition, it is possible to suitably determine whether the surface mounting electronic module is positioned in a normal state or in an abnormal state with respect to the guide member through a voltage detecting means, and it is possible to provide a surface mounting electronic module having no electric circuit being broken when being tested.

Further, since the external circuit connecting terminal portions and the three grounding terminal portions are formed of lands provided on a bottom surface of the insulating substrate or terminals made of a metal plate mounted on the insulating substrate, its structure is simple. Therefore, it is possible to provide a low-priced surface mounting electronic module.

Further, since the non-conductive portion is not electrically connected to the electric circuit and is formed of the land provided on the bottom surface of the insulating substrate or the terminal made of the metal plate mounted on the insulating substrate, the non-conductive portion can be formed of the same material as that of the external circuit connecting terminal portion or grounding terminal porting and its structure is simple. Therefore, it is possible to provide a low-priced surface mounting electronic module.

Further, since the non-conductive portion is formed of an insulating portion which does not have the terminal portion, the number of the terminal portions can be reduced. Therefore, it is possible to provide a low-priced surface mounting electronic module.

Further, since the three grounding terminal portions and the non-conductive portion are arranged at four corners of the insulating substrate, their locations are clear. In particular, the non-conductive portion can be preferably formed on the corner that has little wiring pattern.

Further, a method of testing a surface mounting electronic module of the present invention comprises a surface mounting electronic module; a guide member for positioning the surface mounting electronic module; first probes connected to the external circuit connecting terminal portions; at least three second probes provided so as to correspond to three of the three grounding terminal portions and the non-conductive portion; and a voltage detecting means arranged between the three second probes, wherein the voltage detecting means determines whether the surface mounting electronic module is positioned in a normal state or in an abnormal state with respect to the guide member.

In this way, since the voltage detecting means arranged between the three second probes determines whether the surface mounting electronic module is positioned in a normal state or in an abnormal state with respect to the guide member, the voltage detecting means can accurately detect four inserting types in a square insulating substrate and two inserting types in a rectangular substrate. Therefore, it is possible to provide a method of testing a surface mounting electronic module having no electric circuit being broken when being tested.

Further, one of the three second probes is connected to a power supply, and the remaining two second probes are connected to a ground. When one second probe connected to the power supply comes into contact with the non-conductive portion and the remaining two second probes connected to the ground come into contacts with the two grounding terminal portions, the voltage detecting means detects a power supply voltage and determines that the surface mounting electronic module is positioned in the normal state with respect to the guide member. In addition, when one second probe connected to the power supply comes into contact with the grounding terminal portion and the remaining two second probes connected to the ground come into contacts with the two grounding terminal portions or one grounding terminal portion and the non-conductive portion, the voltage detecting means detects a voltage of 0V and determines that the surface mounting electronic module is positioned in the abnormal state with respect to the guide member. Therefore, it is possible to provide a method of testing a surface mounting electronic module having no electric circuit being broken when being tested.

Furthermore, a method of testing a surface mounting electronic module of the present invention comprises a surface mounting electronic module having a rectangular insulating substrate; a guide member for positioning the surface mounting electronic module; first probes connected to the external circuit connecting terminal portions; at least two second probes provided so as to correspond to one grounding terminal portion and one non-conductive portion or two grounding terminal portions; and a voltage detecting means arranged between the two second probes. The voltage detecting means determines whether the surface mounting electronic module is positioned in a normal state or in an abnormal state with respect to the guide member. As a result, it is possible to accurately detect two inserting types of the surface mounting electronic module with respect to the guide member. Therefore, it is possible to provide a method of testing a surface mounting electronic module having no electric circuit being broken when being tested.

Further, one of the two second probes is connected to a power supply and one of the remaining second probes is connected to a ground. When the one second probe connected to the power supply comes into contact with the non-conductive portion and the one of the remaining second probes connected to the ground comes into contacts with one grounding terminal portion, the voltage detecting means detects a power supply voltage. In addition, when the one second probe connected to the power supply comes into contact with one grounding terminal portion and the one of the remaining second probes connected to the ground comes into contact with another grounding terminal portion, the voltage detecting means detects a voltage of 0V. When the voltage detected by the voltage detecting means is one of the power supply voltage and the voltage of 0V, the voltage detecting means determines that the surface mounting electronic module is positioned in the normal state with respect to the guide member, and when the voltage detected by the voltage detecting means is the other of the power supply voltage and the voltage of 0 V, the voltage detecting means determines that the surface mounting electronic module is positioned in the abnormal state with respect to the guide member. As a result, it is possible to accurately determine whether the surface mounting electronic module is positioned in the normal state or in the abnormal state through the voltage detecting means. Therefore, it is possible to provide a method of testing a surface mounting electronic module having no electric circuit being broken when being tested.

Further, after the voltage detecting means determines that the surface mounting electronic module is positioned in the normal state with respect to the guide member, an electric test is performed by the first probe. Therefore, it is possible to provide a method of easily testing a surface mounting electronic module.

Further, the method of testing the surface mounting electronic module further comprises a testing device for performing an electric test. The testing device is provided with a display unit capable of determining the normal state or abnormal state of the surface mounting electronic module by a visual observation. As a result, it is possible to accurately determine whether the surface mounting electronic module is positioned in the normal state or in the abnormal state with respect to the guide member through the display unit and it is possible to perform an accurate test. Therefore, it is possible to provide a method of easily testing a surface mounting electronic module.

Further, the method of testing the surface mounting electronic module further comprises a testing device for performing an electric test. The testing device is provided with a voice generating unit capable of determining the normal state or abnormal state of the surface mounting electronic module by a voice. As a result, it is possible to accurately determine whether the surface mounting electronic module is positioned in the normal state or in the abnormal state with respect to the guide member through the display unit and it is possible to perform an accurate test. Therefore, it is possible to provide a method of easily testing a surface mounting electronic module.

### BRIEF DESCRIPTION OF THE DRAWINGS

FIG. 1 is a perspective view of a surface mounting electronic module according to a first embodiment of the present invention as viewed from a bottom surface;
FIG. 2 is an explanatory view illustrating an outline of a method of testing the surface mounting electronic module according to the first embodiment of the present invention;
FIG. 3 is an explanatory view illustrating a first example of a voltage detecting means in the method of testing the surface mounting electronic module according to the first embodiment of the present invention;
FIG. 4 is an explanatory view illustrating a first insertion example of the surface mounting electronic module in the method of testing the surface mounting electronic module according to the first embodiment of the present invention;
FIG. 5 is an explanatory view illustrating a second insertion example of the surface mounting electronic module in the method of testing the surface mounting electronic module according to the first embodiment of the present invention;
FIG. 6 is an explanatory view illustrating a third insertion example of the surface mounting electronic module in the method of testing the surface mounting electronic module according to the first embodiment of the present invention;
FIG. 7 is an explanatory view illustrating a fourth insertion example of the surface mounting electronic module in the method of testing the surface mounting electronic module according to the first embodiment of the present invention;
FIG. 8 is a perspective view of a surface mounting electronic module according to a second embodiment of the present invention as viewed from a bottom surface;
FIG. 9 is a perspective view of a surface mounting electronic module according to a third embodiment of the present invention as viewed from a bottom surface;
FIG. 10 is a perspective view of a surface mounting electronic module according to a fourth embodiment of the present invention as viewed from a bottom surface;
FIG. 11 is a perspective view of a surface mounting electronic module according to a fifth embodiment of the present invention as viewed from a bottom surface;
FIG. 12 is an explanatory view illustrating a second example of a voltage detecting means in the method of testing the surface mounting electronic module according to the fifth embodiment of the present invention;
FIG. 13 is an explanatory view illustrating a first insertion example of the surface mounting electronic module in the method of testing the surface mounting electronic module according to the fifth embodiment of the present invention;
FIG. 14 is an explanatory view illustrating a second insertion example of the surface mounting electronic module in the method of testing the surface mounting electronic module according to the fifth embodiment of the present invention;
FIG. 15 is a perspective view of a surface mounting electronic module according to a sixth embodiment of the present invention as viewed from a bottom surface;
FIG. 16 is a perspective view of a surface mounting electronic module according to a seventh embodiment of the present invention as viewed from a bottom surface;
FIG. 17 is a perspective view of a surface mounting electronic module according to an eighth embodiment of the present invention as viewed from a bottom surface;
FIG. 18 is a front view of a surface mounting electronic module according to a ninth embodiment of the present invention;
FIG. 19 is a bottom view of the surface mounting electronic module according to the ninth embodiment of the present invention;
FIG. 20 is a front view of a surface mounting electronic module according to a tenth embodiment of the present invention;
FIG. 21 is a bottom view of the surface mounting electronic module according to the tenth embodiment of the present invention;
FIG. 22 is a bottom view of a surface mounting electronic module according to an eleventh embodiment of the present invention;
FIG. 23 is a plan view of a conventional surface mounting electronic module; and
FIG. 24 is an explanatory view illustrating an outline of a method of testing the conventional surface mounting electronic module.

### DESCRIPTION OF THE PREFERRED EMBODIMENTS

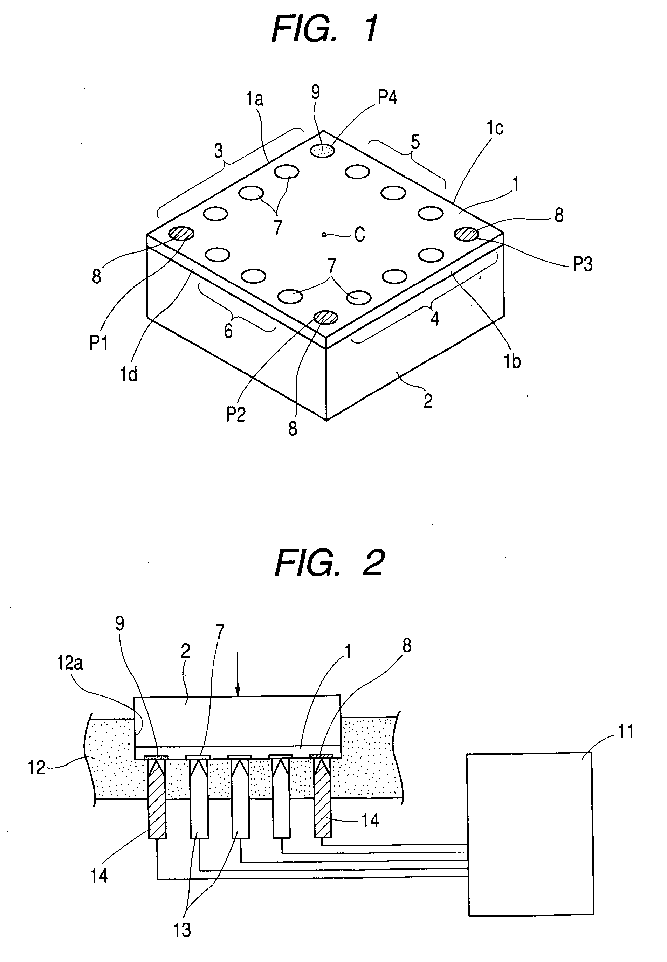

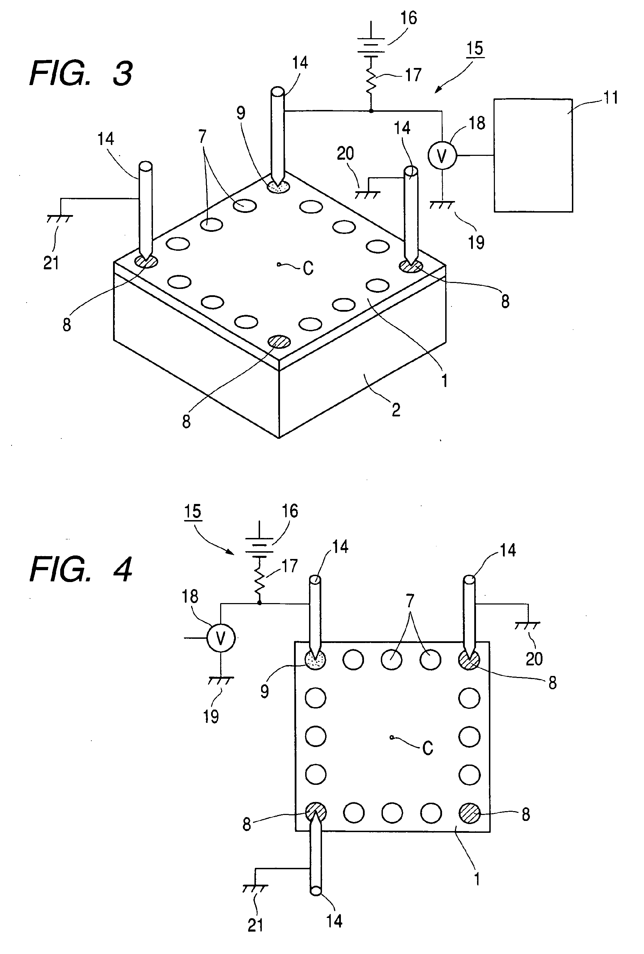

A surface mounting electronic module and a method of testing the same according to the present invention will be described with reference to the accompanying drawings. FIG. 1 is a perspective view of a surface mounting electronic module according to a first embodiment of the present invention as viewed from a bottom surface, FIG. 2 is an explanatory view illustrating an outline of a method of testing the surface mounting electronic module according to the first embodiment of the present invention, and FIG. 3 is an explanatory view illustrating a first example of a voltage detecting means in the method of testing the surface mounting electronic module according to the first embodiment of the present invention.

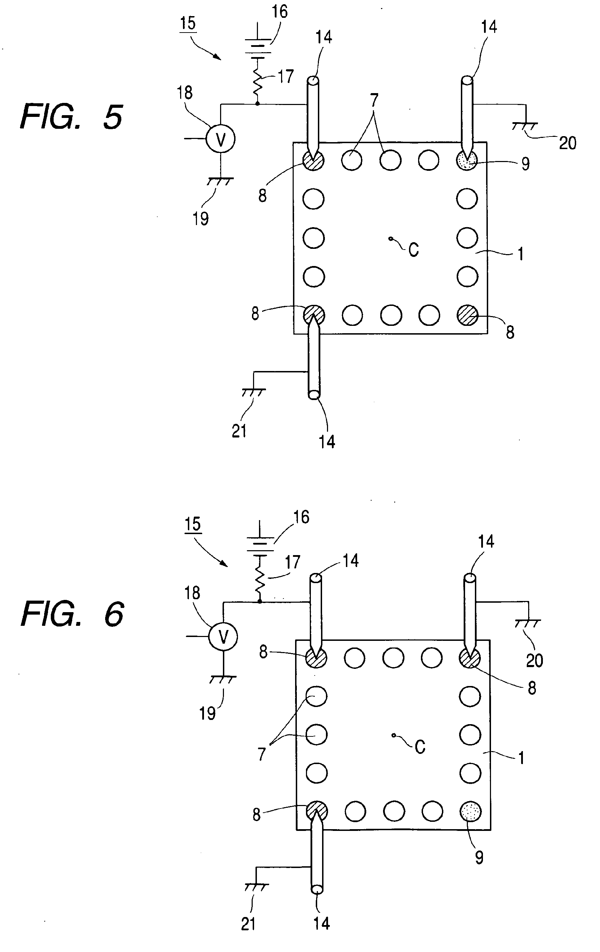

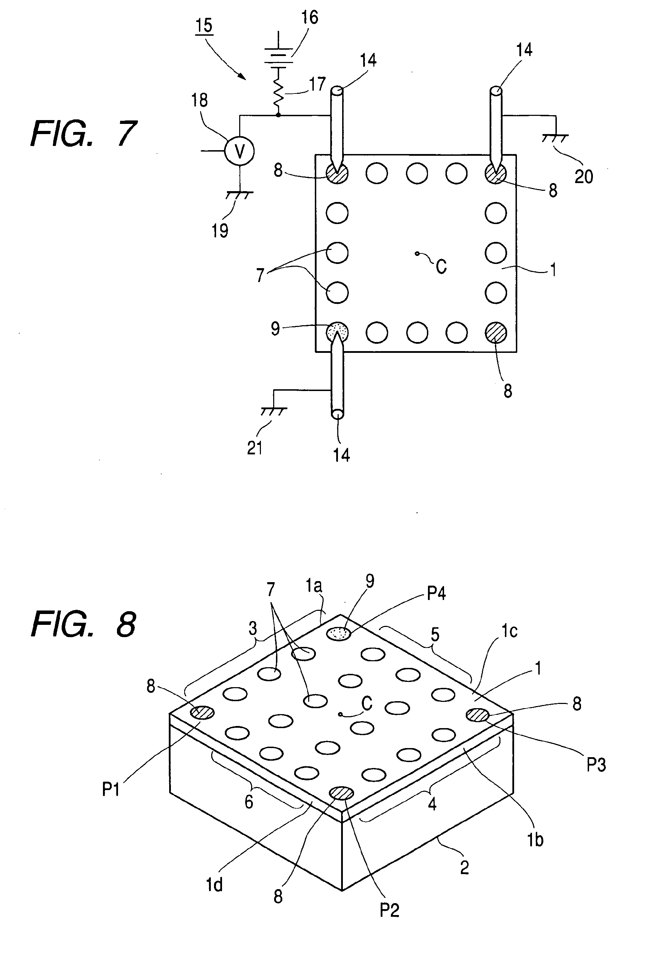

Further, FIG. 4 is an explanatory view illustrating a first insertion example of the surface mounting electronic module in the method of testing the surface mounting electronic module according to the first embodiment of the present invention, FIG. 5 is an explanatory view illustrating a second insertion example of the surface mounting electronic module in the method of testing the surface mounting electronic module according to the first embodiment of the present invention, FIG. 6 is an explanatory view illustrating a third insertion example of the surface mounting electronic module in the method of testing the surface mounting electronic module according to the first embodiment of the present invention, and FIG. 7 is an explanatory view illustrating a fourth insertion example of the surface mounting electronic module in the method of testing the surface mounting electronic module according to the first embodiment of the present invention.

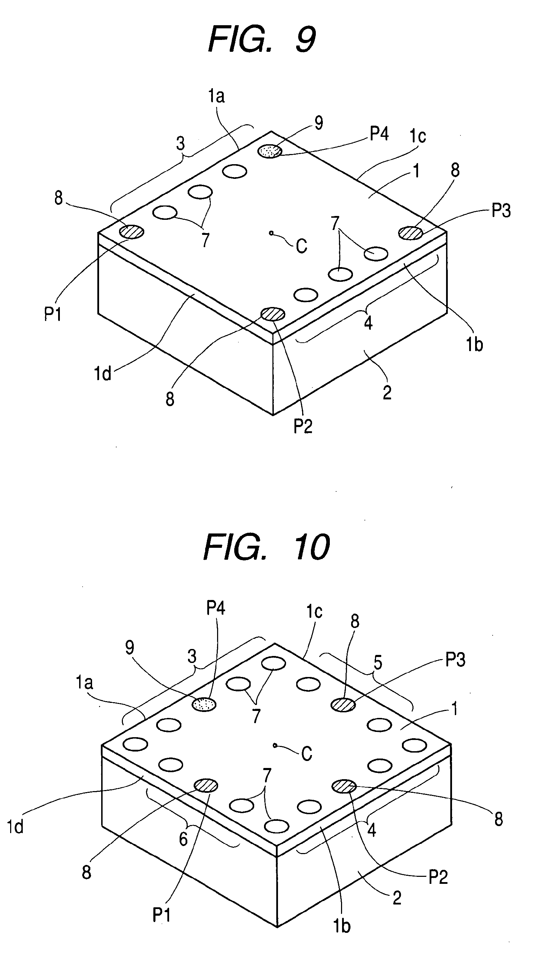

Further, FIG. 8 is a perspective view of a surface mounting electronic module according to a second embodiment of the present invention as viewed from a bottom surface, FIG. 9 is a perspective view of a surface mounting electronic module according to a third embodiment of the present invention as viewed from a bottom surface, and FIG. 10 is a perspective view of a surface mounting electronic module according to a fourth embodiment of the present invention as viewed from a bottom surface.

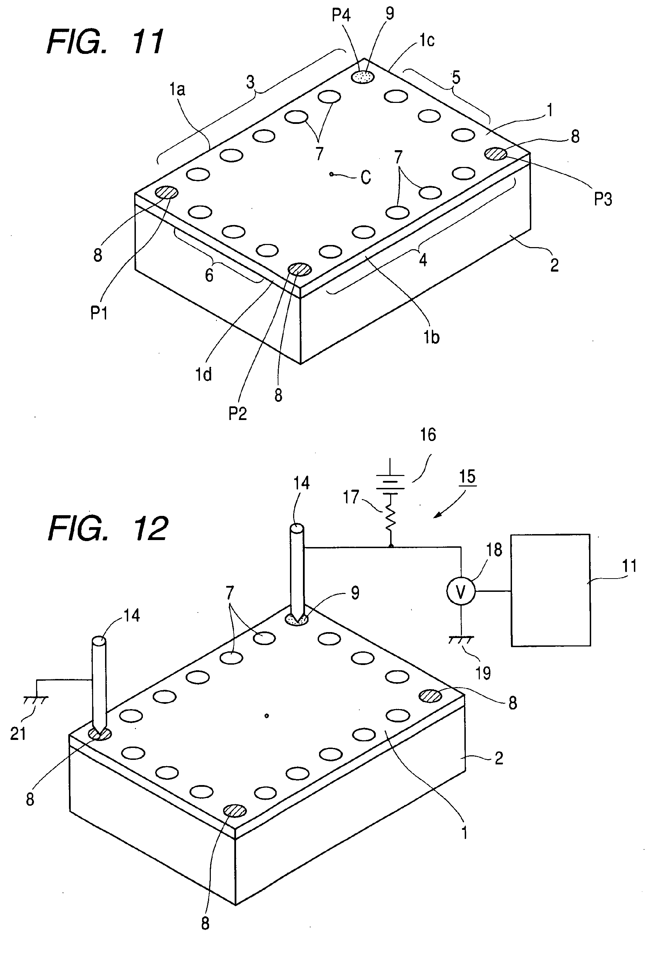

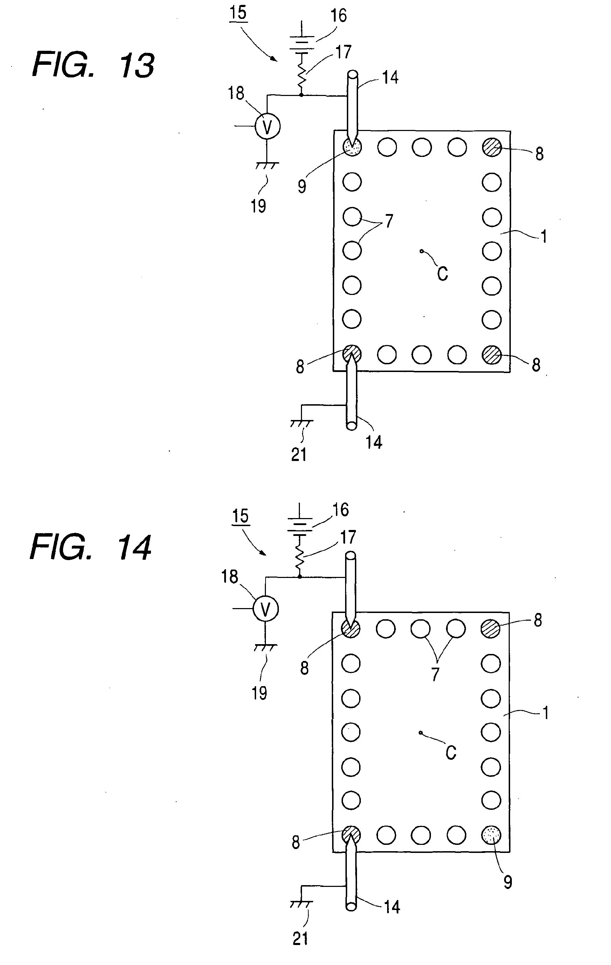

Further, FIG. 11 is a perspective view of a surface mounting electronic module according to a fifth embodiment of the present invention as viewed from a bottom surface; FIG. 12 is an explanatory view illustrating a second example of a voltage detecting means in a method of testing the surface mounting electronic module according to the fifth embodiment of the present invention; FIG. 13 is an explanatory view illustrating a first insertion example of the surface mounting electronic module in the method of testing the surface mounting electronic module according to the fifth embodiment of the present invention, and FIG. 14 is an explanatory view illustrating a second insertion example of the surface mounting electronic module in the method of testing the surface mounting electronic module according to the fifth embodiment of the present invention.

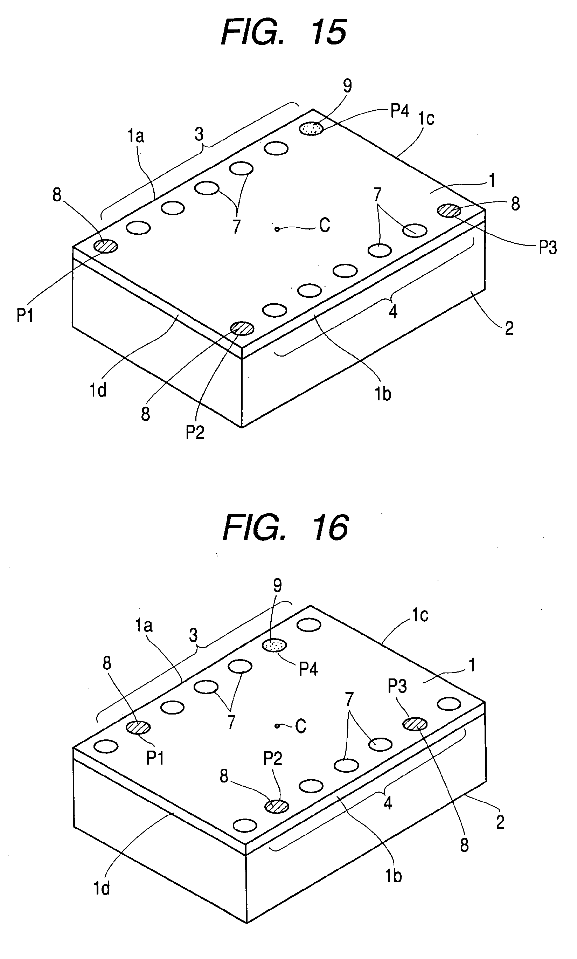

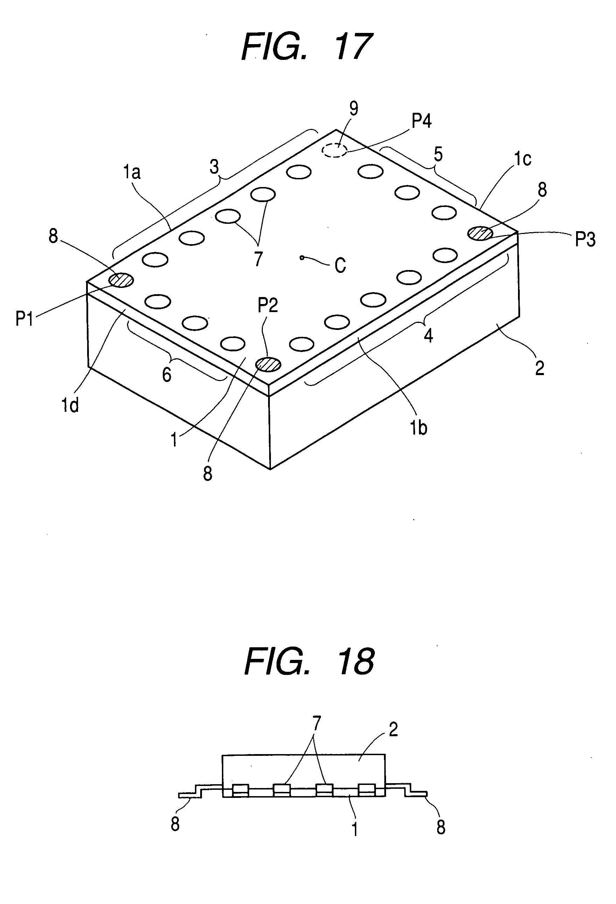

Further, FIG. 15 is a perspective view of a surface mounting electronic module according to a sixth embodiment of the present invention as viewed from a bottom surface; FIG. 16 is a perspective view of a surface mounting electronic module according to a seventh embodiment of the present invention as viewed from a bottom surface; and FIG. 17 is a perspective view of a surface mounting electronic module according to an eighth embodiment of the present invention as viewed from a bottom surface.

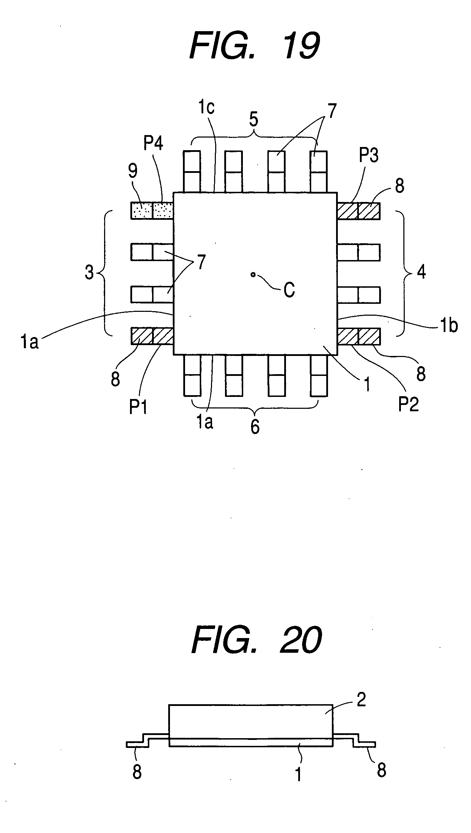

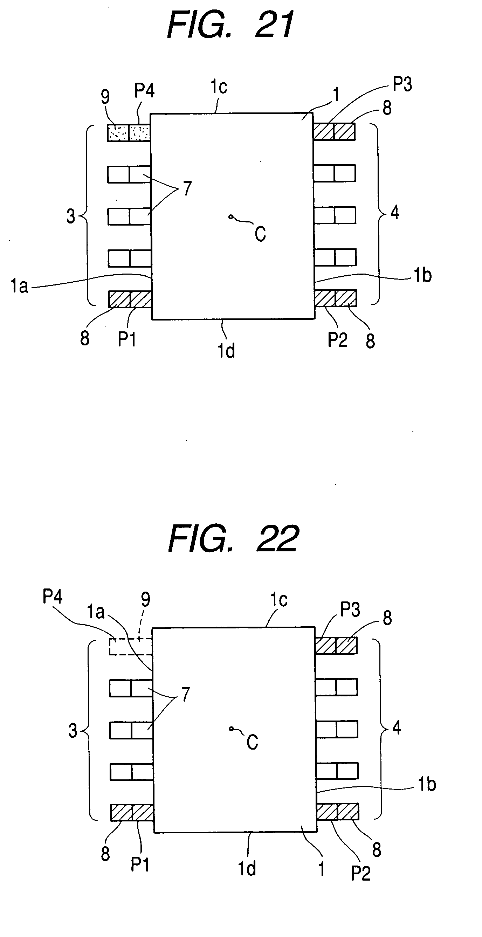

Further, FIG. 18 is a front view of a surface mounting electronic module according to a ninth embodiment of the present invention, FIG. 19 is a bottom view of the surface mounting electronic module according to the ninth embodiment of the present invention, FIG. 20 is a front view of a surface mounting electronic module according to a tenth embodiment of the present invention, FIG. 21 is a bottom view of the surface mounting electronic module according to the tenth embodiment of the present invention, and FIG. 22 is a bottom view of a surface mounting electronic module according to an eleventh embodiment of the present invention.

Next, a structure of a surface mounting electronic module according to a first embodiment of the present invention will be described with reference to FIG. 1. An insulating substrate 1 is used for a short-distance wireless apparatus or semiconductor device. The insulating substrate 1 has a square shape, a desired electric circuit (not shown) is formed on one surface of the insulating substrate 1, and the electric circuit is covered with a covering member 2 such as a covering portion or a cover.

In addition, the insulating substrate 1 has two pairs of sides 1a and 1b and 1c and 1d opposing each other. In the insulating substrate 1, terminal groups 3, 4, 5, and 6 arranged in line along each of the sides 1a to 1d are provided.

The terminal groups 3 to 6 have a plurality of external circuits connecting terminal portions 7, three grounding terminal portions 8 connected to a grounding conductor (grounding conductor pattern), and a non-conductive portion 9. The external circuit connecting terminal portions 7, the grounding terminal portions 8 and the non-conductive portion 9 are formed of a soldering land portion provided on a bottom surface of the insulating substrate 1. The non-conductive portion 9 is not electrically to an electric circuit to thus form an island-shaped land portion.

In addition, the three grounding terminal portions 8 and one non-conductive portion 9 are arranged at first to fourth point symmetric locations P1, P2, P3, and P4 positioned around a center C of the square insulating substrate 1 in an equal distance. Specifically, the three grounding terminal portions 8 are respectively arranged at the first to third locations P1 to P3 and one non-conductive portion 9 is arranged at the fourth location P4. In the first embodiment, the three grounding terminal portions 8 and the non-conductive portion 9 are arranged at corner portions of the insulating substrate 1.

In addition, the external circuit connecting terminal portions 7 and the three grounding terminal portions 8 are connected to the electric circuit so that the surface mounting electronic module of the present invention is formed. The surface mounting electronic module having the above-mentioned structure is constituted such that the surface mounting electronic module is mounted on a mother substrate (not shown) of an electronic apparatus, it's external circuit connecting terminal portions 7 and the three grounding terminal portions 8 are soldered on a wiring pattern (not shown) of the mother substrate and the surface mounting electronic module is surface-mounted on the electronic apparatus.

The surface mounting electronic module of the present invention having the above-mentioned structure is electrically tested prior to shipment. A testing device will be described with reference to FIGS. 2 to 7. The testing device comprises a measuring instrument 11 for measuring an electric value, a guide member 12 having a concave portion 12a for locating the surface mounting electronic module, a plurality of first probes 13 attached to the guide member 12 and connected to the measurement instrument 11, and at least three second probes 14 attached to the guide member 12 and connected to a voltage detecting means 15 provided in the measuring instrument 11.

In addition, as shown in FIG. 3 in particular, the voltage detecting means 15 according to the first embodiment includes a power supply 16 (for example, 5V) having a low voltage, a protective resistor 17 connected to the power supply 16, one second probe 14 connected to the protective resistor 17, a voltage detecting portion 18 connected in parallel to one second probe 14 and connected to the protective resistor 17, a ground 19 to which one end of the voltage detecting portion 18 is connected, and grounds 20 and 21 to which the remaining two second probes 14 are connected.

In addition, the first probes 13 are arranged so as to be connectable to the external circuit connecting terminal portions 7 and the three second probes 14 are arranged so as to correspond to the three grounding terminal portions 8 or one non-conductive portion 9.

Next, the test method will be described. First, the surface mounting electronic module is inserted in the concave portion 12a in a state in which the square insulating substrate 1 is guided in the concave portion 12a of the guide member 12.

At this time, the plurality of first probes 13 is connected to the external circuit connecting terminal portions 7 and the second probes 14 come into contacts with the grounding terminal portions 8 or non-conductive portion 9.

In addition, inserting types by which the surface mounting electronic module is inserted into the concave portion 12a are four as shown in FIGS. 4 to 7 (first to fourth inserting types).

As shown in FIGS. 3 and 4, according to the first inserting type, the second probe 14 connected to the power supply 16 comes into contact with the non-conductive portion 9 and the remaining two second probes 14 come into contacts with the two grounding terminal portions 8, respectively.

Therefore, according to the first inserting type, a current does not flow from the non-conductive portion 9 coming in contact with the second probe 14 so that the voltage supplied from the power supply 16 is applied to the voltage detecting portion 18 as it is. As a result, the power supply voltage (5V) is detected in the voltage detecting portion 18.

In addition, as shown in FIG. 5, according to the second inserting type, the second probe 14 connected to the power supply 16 comes into contact with the grounding terminal portion 8 and the remaining two second probes 14 come into contacts with the grounding terminal portion 8 and the non-conductive portion 9, respectively.

Therefore, according to the second inserting type, a current flowing from the grounding terminal portion 8 coming in contact with the second probe 14 flows into another grounding terminal portion 8 coming in contact with the second probe 14 through the grounding conductor, and the current flows into a ground 21 through the second probe 14 connected to the grounding terminal 8. As a result, a voltage of 0V is detected in the voltage detecting portion 18.

In addition, as shown in FIG. 6, according to the third inserting type, the second probe 14 connected to the power supply 16 comes into contact with the grounding terminal portion 8 and the remaining two second probes 14 come into contacts with the two grounding terminal portions 8, respectively, similarly to the second inserting type of FIG. 5. Therefore, according to the third inserting type, currents flowing from the grounding terminal portions 8 coming in contacts with the second probes 14 flow into the grounds 20 and 21. As a result, a voltage of 0V is detected in the voltage detecting portion 18.

In addition, as shown in FIG. 7, according to the fourth inserting type, the second probe 14 connected to the power supply 16 comes into contact with the grounding terminal portion 8 and the remaining two second probes 14 come into contacts with the grounding terminal portion 8 and the non-conductive portion 9, respectively, similarly to the second inserting type of FIG. 5. Therefore, according to the fourth inserting type, a current flowing from the grounding terminal portions 8 coming in contacts with the second probes 14 flows into the grounding portion 20. As a result, a voltage of 0V is detected in the voltage detecting portion 18.

In this manner, the surface mounting electronic module is constituted such that states of the four inserting types are electrically determined, its state is determined as a normal state when the voltage detecting portion 18 detects the power supply voltage (5V), and its state is determined as an abnormal state when the voltage detecting portion 18 detects 0V.

In addition, at the time of the normal state that the voltage detecting portion 18 had detected the power supply voltage (5V), an electric test is automatically performed by the first probes 13 or the second probes 14.

In addition, although not shown in drawings, the testing device has a display unit capable of determining the normal state or abnormal state of the surface mounting electronic module by a visual observation or a voice generating unit capable of determining the normal state or abnormal state of the surface mounting electronic module by a voice, and thus it is possible to suitably determine whether the surface mounting electronic module is in the normal state or in the abnormal state.

In addition, in the present embodiment, the second probes 14 are three, but the second probes 14 may be four. Therefore, the four second probes 14 may come in contacts with the three grounding terminal portions 8 and one non-conductive portion 9.

In addition, FIG. 8 shows a surface mounting electronic module according to a second embodiment of the present invention. Since a structure of the surface mounting electronic module of the second embodiment is the same as that of the surface mounting electronic module of the first embodiment, except that external circuit connecting terminal portions 7 are provided at central portions on a bottom surface of an insulating substrate 1, constituent elements of the second embodiment that are the same as those of the first embodiment are denoted by the same reference numerals and a description thereof is omitted.

In addition, FIG. 9 shows a surface mounting electronic module according to a third embodiment of the present invention. Since a structure of the surface mounting electronic module of the third embodiment is the same as that of the surface mounting electronic module of the first embodiment, except that terminal groups 3 and 4 are provided along a pair of opposing sides 1a and 1b of an insulating substrate, constituent elements of the second embodiment that are the same as those of the first embodiment are denoted by the same reference numerals and a description thereof is omitted.

In addition, FIG. 10 shows a surface mounting electronic module according to a fourth embodiment of the present invention. Since a structure of the surface mounting electronic module of the fourth embodiment is the same as that of the surface mounting electronic module of the first embodiment, except that three grounding terminal portions 8 and one non-conductive portion 9 are arranged at first to fourth locations P1 to P4 of centers of sides 1a to ld which are point symmetrical locations positioned around a center C of an insulating substrate 1 in an equal distance, constituent elements of the second embodiment that are the same as those of the first embodiment are denoted by the same reference numerals and a description thereof is omitted.

In addition, FIG. 11 shows a surface mounting electronic module according to a fifth embodiment of the present invention. Since a structure of the surface mounting electronic module of the fifth embodiment is the same as that of the surface mounting electronic module of the first embodiment, except that an insulating substrate 1 has a rectangular shape, and three grounding terminal portions 8 and one non-conductive portion 9 are arranged at first to fourth locations P1 to P4 which are point symmetrical locations positioned around a center C of the insulating substrate 1 in an equal distance, constituent elements of the second embodiment that are the same as those of the first embodiment are denoted by the same reference numerals and a description thereof is omitted.

In addition, as shown in FIGS. 12 to 14, since a second example of the voltage detecting means 15 of the testing device which is used in the fifth embodiment is the same as the first example of the voltage detecting means 15 of the testing device, except that one second probe 14 of two second probes 14 is connected to a power supply 16 and the other second probe 14 is connected to a ground 21, constituent elements of the second example that are the same as those of the first example are denoted by the same reference numerals and a description thereof is omitted.

Next, a test method will be described. First, the surface mounting electronic module is inserted in the concave portion 12a in a state in which the rectangular insulating substrate 1 is guided in the concave portion 12a of the guide member 12, similarly to the first embodiment. However, inserting types by which the surface mounting electronic module is inserted into the concave portion 12a are two as shown in FIGS. 13 to 14 (first and second inserting types).

In addition, as shown in FIGS. 12 and 13, according to the first inserting type, the second probe 14 connected to the power supply 16 comes into contact with the non-conductive portion 9 and the other second probe 14 comes into contact with one grounding terminal portion 8.

Therefore, according to the first inserting type, a current does not flow from the non-conductive portion 9 coming in contact with the second probe 14 and the voltage supplied from the power supply 16 is applied to the voltage detecting portion 18 as it is. As a result, a power supply voltage (5V) is detected in the voltage detecting portion 18.

In addition, as shown in FIG. 14, according to the second inserting type, the second probe 14 connected to the power supply 16 comes into contact with the grounding terminal portion 8 and the other second probe 14 comes into contact with the grounding terminal portion 8.

Therefore, according to the second inserting type, a current flowing from the grounding terminal portion 8 coming in contact with the second probes 14 flows into another grounding terminal portion 8 coming in contact with the second probe 14 through the grounding conductor, and the current flows into a ground 21 through the second probe 14. As a result, a voltage of 0V is detected in the voltage detecting portion 18.

In this manner, the surface mounting electronic module according to the fifth embodiment is constituted such that states of the two inserting types are electrically determined, one state is determined as a normal state and the other state is determined as an abnormal state when the voltage detecting portion 18 detects the power supply voltage (5V) or the voltage detecting portion 18 detects 0V.

In addition, at the time of the normal state that the voltage detecting portion 18 had detected the power supply voltage (5V) or 0V, an electric test is automatically performed by the first probes 13 or the second probes 14.

In addition, in the present embodiment, the second probes 14 are two, but the second probes 14 may be three or four. Therefore, the second probes 14 may come in contacts with the grounding terminal portions 8 and one non-conductive portion 9.

In addition, FIG. 15 shows a surface mounting electronic module according to a sixth embodiment of the present invention. Since a structure of the surface mounting electronic module of the sixth embodiment is the same as that of the surface mounting electronic module of the fifth embodiment, except that terminal groups 3 and 4 are provided along a pair of opposing sides 1a and 1b of an insulating substrate 1, constituent elements of the sixth embodiment that are the same as those of the fifth embodiment are denoted by the same reference numerals and a description thereof is omitted.

In addition, FIG. 16 shows a surface mounting electronic module according to a seventh embodiment of the present invention. Since a structure of the surface mounting electronic module of the seventh embodiment is the same as that of the surface mounting electronic module of the sixth embodiment, except that three grounding terminal portions 8 and one non-conductive portion 9 are arranged at first to fourth locations P1 to P4 which are point symmetric locations positioned around the center C of an insulating substrate 1 in an equal distance and which are spaced apart from corner portions of the insulating substrate 1, constituent elements of the seventh embodiment that are the same as those of the sixth embodiment are denoted by the same reference numerals and a description thereof is omitted.

In addition, FIG. 17 shows a surface mounting electronic module according to an eighth embodiment of the present invention. Since a structure of the surface mounting electronic module of the eighth embodiment is the same as that of the surface mounting electronic module of the fifth embodiment, except that one non-conductive portion 9 is formed of an insulating portion by removing a terminal portion, constituent elements of the eighth embodiment that are the same as those of the fifth embodiment are denoted by the same reference numerals and a description thereof is omitted.

In addition, FIGS. 18 and 19 show a surface mounting electronic module according to a ninth embodiment of the present invention. Since a structure of the surface mounting electronic module of the ninth embodiment is the same as that of the surface mounting electronic module of the first embodiment, except that external circuit connecting terminal portions 7, grounding terminal portions 8, and a non-conductive portion 9 are formed of terminals made of metal plates and the terminals protrude outward from a square insulating substrate 1, constituent elements of the ninth embodiment that are the same as those of the first embodiment are denoted by the same reference numerals and a description thereof is omitted.

In addition, FIGS. 20 and 21 show a surface mounting electronic module according to a tenth embodiment of the present invention. Since a structure of the surface mounting electronic module of the tenth embodiment is the same as that of the surface mounting electronic module of the ninth embodiment, except that terminal groups 3 and 4 are provided along a pair of opposing sides 1a and 1b of a rectangular insulating substrate 1, constituent elements of the tenth embodiment that are the same as those of the ninth embodiment are denoted by the same reference numerals and a description thereof is omitted.

In addition, FIG. 22 shows a surface mounting electronic module according to an eleventh embodiment of the present invention. Since a structure of the surface mounting electronic module of the eleventh embodiment is the same as that of the surface mounting electronic module of the tenth embodiment, except that a non-conductive portion 9 is formed by removing a terminal made of a metal plate, constituent elements of the eleventh embodiment that are the same as those of the tenth embodiment are denoted by the same reference numerals and a description thereof is omitted.

## Claims

1. A surface mounting electronic module comprising:
a square or rectangular insulating substrate having formed with a desired electric circuit; and
a plurality of terminal groups arranged along sides of the insulating substrate at least opposing each other,
wherein the plurality of terminal groups has a plurality of external circuits connecting terminal portions, three grounding terminal portions connected to a grounding conductor and one non-conductive portion, and
the insulating substrate has first to fourth point symmetric locations positioned around a center of the insulating substrate in an equal distance, the three grounding terminal portions are respectively arranged at the first to third locations, and the non-conductive portion is arranged at the fourth location.

2. The surface mounting electronic module according to claim 1,
wherein the external circuit connecting terminal portions and the three grounding terminal portions are formed of lands provided on a bottom surface of the insulating substrate or terminals made of a metal plate mounted on the insulating substrate.

3. The surface mounting electronic module according to claim 1 or 2,
wherein the non-conductive portion is not electrically connected to the electric circuit and is formed of the land provided on the bottom surface of the insulating substrate or the terminal made of the metal plate mounted on the insulating substrate.

4. The surface mounting electronic module according to claim 1 or 2,
wherein the non-conductive portion is formed of an insulating portion which does not have the terminal.

5. The surface mounting electronic module according to any one of claims 1 to 4,
wherein the three grounding terminal portions and the non-conductive portion are arranged at four corners of the insulating substrate.

6. A method of testing a surface mounting electronic module including a square or rectangular insulating substrate having formed with a desired electric circuit and a plurality of terminal groups arranged along sides of the insulating substrate at least opposing each other,
wherein the plurality of terminal groups have a plurality of external circuits connecting terminal portions, three grounding terminal portions connected to a grounding conductor and one non-conductive portion,
the insulating substrate has first to fourth point symmetric locations positioned around a center of the insulating substrate in an equal distance,
the three grounding terminal portions are respectively arranged at the first to third locations, and the non-conductive portion is arranged at the fourth location,
a testing device includes a measuring instrument, a guide member for locating the surface mounting electronic module, first probes connected to the external circuit connecting terminal portions, at least three second probes provided so as to correspond to three of the three grounding terminal portions and the non-conductive portion, and a voltage detecting means arranged between the three second probes, and
the method comprises a step of determining whether the surface mounting electronic module is positioned in a normal state or in an abnormal state with respect to the guide member, by the voltage detecting means.

7. The method of testing the surface mounting electronic module according to claim 6,
wherein one of the three second probes is connected to a power supply, the remaining two second probes are connected to a ground,
when the one second probe connected to the power supply comes into contact with the non-conductive portion and the remaining two second probes connected to the ground come into contacts with the two grounding terminal portions, the voltage detecting means detects a power supply voltage and determines that the surface mounting electronic module is positioned in the normal state with respect to the guide member,
when the one second probe connected to the power supply comes into contact with the grounding terminal portion and the remaining two second probes connected to the ground come into contacts with the two grounding terminal portions or one grounding terminal portion and the non-conductive portion, the voltage detecting means detects a voltage of 0V and determines that the surface mounting electronic module is positioned in the abnormal state with respect to the guide member.

8. A method of testing a surface mounting electronic module including a rectangular insulating substrate having formed with a desired electric circuit and a plurality of terminal groups arranged along sides of the insulating substrate at least opposing each other,
wherein the plurality of terminal groups have a plurality of external circuits connecting terminal portions, three grounding terminal portions connected to a grounding conductor and one non-conductive portion,
the insulating substrate has first to fourth point symmetric locations positioned around a center of the insulating substrate in an equal distance,
the three grounding terminal portions are respectively arranged at the first to third locations, and the non-conductive portion is arranged at the fourth location, and
a testing device includes a measuring instrument, a guide member for locating the surface mounting electronic module, first probes connected to the external circuit connecting terminal portions, at least two second probes provided so as to correspond to one grounding terminal portion and one non-conductive portion or two grounding terminal portions, and a voltage detecting means arranged between the two second probes, and
the method comprises a step of determining whether the surface mounting electronic module is positioned in a normal state or in an abnormal state with respect to the guide member, by the voltage detecting means.

9. The method of testing the surface mounting electronic module according to any of claims 6 to 8,
wherein one of the second probes is connected to a power supply and one of the remaining second probes is connected to a ground,
when the one second probe connected to the power supply comes into contact with the non-conductive portion and the one of the remaining second probes connected to the ground comes into contacts with the one grounding terminal portion, the voltage detecting means detects a power supply voltage,
when the one second probe connected to the power supply comes into contact with one grounding terminal portion and the one of the remaining second probes connected to the ground comes into contact with another grounding terminal portion, the voltage detecting means detects a voltage of 0V,
when the voltage detected by the voltage detecting means is one of the power supply voltage and the voltage of 0V, the voltage detecting means determines that the surface mounting electronic module is positioned in the normal state with respect to the guide member,
when the voltage detected by the voltage detecting means is the other of the power supply voltage and the voltage of 0V, the voltage detecting means determines that the surface mounting electronic module is positioned in the abnormal state with respect to the guide member.

10. The method of testing the surface mounting electronic module according to any one of claims 6 to 9,
wherein after the voltage detecting means determines that the surface mounting electronic module is positioned in the normal state with respect to the guide member, an electric test is performed by the first probes.

11. The method of testing the surface mounting electronic module according to claim 10,
wherein the testing device is provided with a display unit for determining the normal state or abnormal state of the surface mounting electronic module by a visual observation.

12. The method of testing the surface mounting electronic module according to claim 10 or 11,
wherein the testing device is provided with a voice generating unit for determining the normal state or abnormal state of the surface mounting electronic module by a voice.
